(19) Europäisches Patentamt
European Patent Office
Office européen des brevets

(11) **EP 4 650 795 A1**

(12) **EUROPÄISCHE PATENTANMELDUNG**

(43) Veröffentlichungstag:
**19.11.2025 Patentblatt 2025/47**

(21) Anmeldenummer: **24175802.8**

(22) Anmeldetag: **14.05.2024**

(51) Internationale Patentklassifikation (IPC):
***G01R 29/12*** *(2006.01)* ***G01R 15/16*** *(2006.01)*

(52) Gemeinsame Patentklassifikation (CPC):
**G01R 29/12; G01R 15/165;** G01R 15/144

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**GE KH MA MD TN**

(71) Anmelder: **Siemens Aktiengesellschaft**
**80333 München (DE)**

(72) Erfinder:
- **GASHI, Indrit**
  **81241 München (DE)**
- **WEIKERT, Robert**
  **92342 Burggriesbach (DE)**
- **RAAB, Oliver**
  **94496 Ortenburg (DE)**
- **SANTOS WILKE, Hans**
  **85599 Parsdorf (DE)**

(74) Vertreter: **Siemens Patent Attorneys**
**Postfach 22 16 34**
**80506 München (DE)**

(54) **SCHALTUNG ZUM ANSTEUERN EINER FELDMESSEINRICHTUNG, VERFAHREN ZUM ANSTEUERN DER FELDMESSEINRICHTUNG UND FELDMESSEINRICHTUNG**

(57) Die Erfindung betrifft eine Schaltung (10) zum Ansteuern einer Feldmesseinrichtung, insbesondere einer mikromechanischen Feldmühle, wobei die Schaltung einen elektrostatischen Aktuator (12) zum Versetzen eines Shutters (14) der Feldmesseinrichtung in Schwingung und einen Aufnehmer (16) zum Erfassen der Schwingung des Shutters (14) umfasst, wobei ein Signalausgang (18) des Aufnehmers (16) zur Rückkopplung mit einem Signaleingang (20) des Aktuators (12) gekoppelt ist, und wobei die Schaltung (10) derart ausgestaltet ist, dass eine über den Signaleingang (20) an den Aktuator (12) anlegbare Ansteuerungsspannung ($u_{DRIVE}$) wenigstens eine Wechselspannungskomponente ($u_{AC} \cdot \sin(\omega t)$) mit einer Frequenz ($\omega$) umfasst, die einem geradzahligen Bruchteil einer Resonanzfrequenz ($\omega_0$) der Schwingung des Shutters (14) entspricht.

Zudem betrifft die Erfindung ein Verfahren zum Ansteuern einer Feldmesseinrichtung mit der obigen Schaltung (10), sowie eine Feldmesseinrichtung.

FIG 1

10
12
14
16
20
22
18
R
24
$U_{Drive}$
$F_{Drive}$
x
$C_{Read}$
$U_{Read}$
$x_0$
$U_{Bias}$
40
38
28
26

EP 4 650 795 A1

## Beschreibung

Die Erfindung betrifft eine Schaltung zum Ansteuern einer Feldmesseinrichtung, insbesondere einer mikromechanischen Feldmühle.

Weiterhin betrifft die Erfindung ein Verfahren zum Ansteuern einer Feldmesseinrichtung, insbesondere einer mikromechanischen Feldmühle, mit der obigen Schaltung.

Ferner betrifft die Erfindung eine Feldmesseinrichtung und insbesondere eine mikromechanische Feldmühle.

Die exakte Bestimmung elektrischer Größen wie elektrischer Strom, elektrische Spannung, elektrischer Energiefluss und elektrische Feldstärke, ist eine wichtige Aufgabe für unterschiedliche Anwendungsfelder, beispielsweise in der industriellen Automatisierung, der Gebäudetechnik oder auch in großflächigen elektrischen Verteilernetzen. Insbesondere im Zuge der voranschreitenden Umstellung auf erneuerbare Energien und der Dezentralisierung der Energieerzeugung wird es in Zukunft von entscheidender Bedeutung sein, elektrische Größen exakt und örtlich aufgelöst abbilden zu können. Insbesondere in der industriellen Automatisierung, sei es in Schaltanlagen oder kleiner dimensioniert auf Leiterplatten wird es zunehmend wichtiger elektrische Größen zuverlässig bestimmen zu können.

Feldmesseinrichtungen zur Messung der elektrischen Feldstärke, auch als Feldmühlen bezeichnet, sind im Stand der Technik bekannt und werden beispielsweise für die Messung atmosphärischer elektrischer Felder genutzt. In den letzten Jahren wurden immer mehr mikroelektromechanische (MEMS) Aufbauten von Feldmühlen bekannt. Der Fokus der Messung mit MEMS-basierten Feldmühlen geht weg von den atmosphärischen Feldern hin zu lokalen Spannungen auf stromführenden Bauteilen sowie hin zum Bereich Personenschutz in elektrostatisch geschützten Bereichen (ESD-Arbeitsplätze).

Eine Herausforderung bei Feldmühlen ist, einen Shutter der Feldmühle, der periodisch Sensorelektroden der Feldmühle von dem zu messenden elektrischen Feld abschirmt, in Schwingen zu bringen und die Schwingung für kontinuierliche Messungen stabil zu halten. Bei MEMS-basierten Feldmühlen sind zudem aufgrund der kleinen Strukturen interne parasitäre Koppelkapazitäten, welche eine Überkopplung zwischen der Ansteuerung des Shutters hin zu den Sensorelektroden, an denen ein Messsignal der Feldmühle für die Auswertung abgegriffen wird, nicht zu vernachlässigen. Wird versucht, den Shutter der Feldmühle mittels seiner Resonanzfrequenz in Schwingung zu versetzen ergibt sich das Problem, dass die Anregung und auch das Messsignal elektrisch auf der gleichen Frequenz schwingen. Jegliche Art der Überkopplung schlägt sich also direkt im Messsignal nieder. Zudem ist es auch nicht möglich, die Überkopplung herauszurechnen.

Folglich stellt es sich als technisch erforderlich dar, eine verbesserte Lösung vorzuschlagen, welche die aus dem Stand der Technik bekannten Nachteile vermeidet. Insbesondere soll die vorzuschlagende Lösung eine genauere Bestimmung einer elektrischen Größe ermöglichen. Daher ist es Aufgabe der Erfindung, die Problematik der kapazitiven Kopplung zu verringern und eine genauere Bestimmung der elektrischen Feldstärke zu ermöglichen.

Diese der vorliegenden Erfindung zugrunde liegenden Aufgaben werden durch eine Schaltung gemäß dem Patentanspruch 1, durch ein Verfahren gemäß dem Patentanspruch 13, und durch eine Feldmesseinrichtung gemäß dem Patentanspruch 14 gelöst.

Bevorzugte Weiterbildungen der Erfindung sind in den zugehörigen Unteransprüchen, der nachfolgenden Beschreibung und der Zeichnung angegeben.

Erfindungsgemäß wird also eine Schaltung zum Ansteuern einer Feldmesseinrichtung, insbesondere einer mikromechanischen Feldmühle, bereitgestellt, wobei die Schaltung einen elektrostatischen Aktuator zum Versetzen eines Shutters der Feldmesseinrichtung in Schwingung und einen Aufnehmer zum Erfassen der Schwingung des Shutters umfasst, wobei ein Signalausgang des Aufnehmers zur Rückkopplung mit einem Signaleingang des Aktuators gekoppelt ist, und wobei die Schaltung derart ausgestaltet ist, dass eine über den Signaleingang an den Aktuator anlegbare Ansteuerungsspannung wenigstens eine Wechselspannungskomponente mit einer Frequenz umfasst, die einem geradzahligen Bruchteil einer Resonanzfrequenz der Schwingung des Shutters entspricht.

Die Aufgabe wird zudem durch ein Verfahren zum Ansteuern einer Feldmesseinrichtung, insbesondere einer mikromechanischen Feldmühle, mit der obigen Schaltung gelöst, umfassend den Schritt

- Versetzen des Shutters in Schwingung durch Anlegen einer Ansteuerungsspannung an den Aktuator mit wenigstens einer Wechselspannungskomponente mit einer Frequenz, die einem geradzahligen Bruchteil einer Resonanzfrequenz der Schwingung des Shutters entspricht.

Weiterhin wird die Aufgabe gelöst durch eine Feldmesseinrichtung, insbesondere mikromechanische Feldmühle, zum Messen einer elektrischen Feldstärke umfassend

- einen geerdeten Shutter, der dazu konfiguriert ist, elektrostatisch in Schwingung versetzt zu werden,
- einen Aktuator zum Versetzen des Shutters in Schwingung, und
- einen Aufnehmer zum Erfassen der Schwingung des Shutters,

wobei der Aufnehmer Sensorelektroden zum Erzeugen eines Messsignales der Feldmesseinrichtung umfasst, wobei die Sensorelektroden mittels des Shutters wiederholt von dem zu messenden Feld abschirmbar und wieder dem Feld aussetzbar sind, derart dass die Sensorelektroden durch Influenz des zu messenden elektrischen Feldes abwechselnd entladbar und aufladbar sind, wobei ein Signalausgang des Aufnehmers zur Rückkopplung mit einem Signaleingang des Aktuators gekoppelt ist, und wobei die Feldmesseinrichtung derart ausgestaltet ist, dass eine über den Signaleingang an den Aktuator anlegbare Ansteuerungsspannung wenigstens eine Wechselspannungskomponente mit einer Frequenz umfasst, die einem geradzahligen Bruchteil einer Resonanzfrequenz der Schwingung des Shutters entspricht.

Die Erfindung basiert auf der Erkenntnis, dass sich durch Ansteuerung des Aktuators mit einem geradzahligen Bruchteil der Resonanzfrequenz der Schwingung des Shutters die Problematik der parasitären Kopplung zwischen der Ansteuerung und den Sensorelektroden aufgrund der geringeren Frequenz verringern lässt. Zudem lässt sich als Resultat dieser Anregung im Frequenzraum eine Trennung der Frequenz des Messignales, das die Resonanzfrequenz des Shutters aufweist, und der Frequenz der Ansteuerungsspannung erreichen. Entsprechend kann eine Überkopplung im Messsignal herausgerechnet werden. Somit ermöglicht die Schaltung und das Verfahren, sowie die Feldmesseinrichtung eine genauere Bestimmung der elektrischen Größe.

Bei elektrostatisch aktuierten Feldmesseinrichtungen erfolgt die Anregung der Schwingung des Shutters durch das Anlegen der Ansteuerspannung - im Folgenden als $u_{DRIVE}$ bezeichnet.

Aus dem Stand der Technik ist bekannt, die Anregung durch Anlegen eines auf einer Gleichspannung $u_{DC}$ überlagertes Wechselspannungssignal $u_{AC}$ gemäß

$$u_{DRIVE} = u_{DC} + u_{AC}\sin(\omega_{ext}t)$$

durchzuführen. Da die Kraft, welche ausgehend von dieser Anregung auf den Shutter wirkt, quadratisch zur angelegten Spannung ist, ergibt sich für die auf den Shutter wirkende Kraft:

$$\begin{aligned} F_{DRIVE} &\sim (u_{DC} + u_{AC}\sin(\omega_{ext}t))^2 \\ &= u_{DC}^2 + 2u_{DC}u_{AC}\sin(\omega_{ext}t) + u_{AC}^2\sin^2(\omega_{ext}t) \\ &= u_{DC}^2 + \frac{u_{AC}^2}{2} + 2u_{DC}u_{AC}\sin(\omega_{ext}t) - \frac{u_{AC}^2}{2}\cos(2\omega_{ext}t) \end{aligned}$$

Entsprechend ist zu erkennen, dass die Kraft drei Frequenzanteile hat. Einen bei w=0, einen bei der gleichen Frequenz wie die Frequenz des angelegten Wechselspannungssignals ($\omega_{ext}$) und einen Anteil bei der doppelten Frequenz (2 $\omega_{ext}$). Im Stand der Technik wird der Term mit der gleichen Frequenz wie das Wechselspannungssignal ($2u_{DC}u_{AC}\sin(\omega_{ext}t)$) zur Ansteuerung verwendet, wobei dazu ein großer Gleichspannungsanteil angelegt wird und die Frequenz des Ansteuerungssignals auf die Resonanzfrequenz des Shutters gelegt wird ($\omega_{ext} = \omega_0$).

Im Gegensatz dazu wird erfindungsgemäß vorliegend der bei doppelter Frequenz liegende Anteil der auf den Shutter wirkenden Kraft, nämlich

$$\frac{u_{AC}^2}{2}\cos(2\omega_{ext}t)$$

zur Ansteuerung verwendet. Dazu weist die über den Signaleingang an den Aktuator anlegbare Ansteuerungsspannung $u_{DRIVE}$ wenigstens die Wechselspannungskomponente, $u_{AC}\cdot\sin(\omega t)$ auf, die einer Frequenz w umfasst, die einem geradzahligen Bruchteil der Resonanzfrequenz wo der Schwingung des Shutters entspricht - also w = $\omega_0/2n$, mit n = {1, 2, 3, 4, ...}. Dies ermöglicht eine Trennung der Frequenz des Messignales, das die Resonanzfrequenz $\omega_0$ des Shutters aufweist, und der Frequenz der Ansteuerungsspannung, die dem geradzahligen Bruchteil der Resonanzfrequenz $\omega_0$ entspricht, beispielsweise $\omega_0/2$, $\omega_0/4$, $\omega_0/6$, oder $\omega_0/8$.

Da der zur Anregung verwendete Term zudem nicht von der Gleichspannung abhängig ist, wird vorliegend auch keine Gleichspannung benötigt. Da die kapazitive Kopplung frequenzabhängig ist, ist durch die geringere Anregungsfrequenz zudem auch die Problematik der kapazitiven Kopplung verringert.

Da der Signalausgang des Aufnehmers zudem zur Rückkopplung mit dem Signaleingang des Aktuators gekoppelt ist, ermöglicht die vorliegende Schaltung, das vorliegende Verfahren und die vorliegende Feldmesseinrichtung eine Selbstschwingung. Dies hat den Vorteil, dass keine exakte Ansteuerung von außen notwendig ist und eine Adaptierung auf verschiedene Umwelteiflüsse leichter zu realisieren ist. Dass die Ansteuerungsspannung $u_{DRIVE}$ wenigstens die Wechselspannungskomponente mit der Frequenz, die dem geradzahligen Bruchteil der Resonanzfrequenz der Schwingung des Shutters entspricht, aufweist, hat zudem den Vorteil, dass das zwecks Rückkopplung initial verarbeitete Nutzsignal, das bei der Resonanzfrequenz des Shutters liegt, nicht die gleiche Frequenz aufweist, wie etwaige übersprechende Anteile der Anregungsfrequenz.

Gemäß einer bevorzugten Weiterbildung der Erfindung ist vorgesehen, dass der geradzahlige Bruchteil der Resonanzfrequenz wo die halbe Resonanzfrequenz $\omega_0/2$ der Schwingung des Shutters ist. Somit ergibt sich eine mit der Resonanzfrequenz wo wirkende Kraft auf den Shutter, während die angelegte Spannung die halbe Resonanzfrequenz $\omega_0/2$ aufweist. Die halbe Resonanzfrequenz vereint den Vorteil, dass die Ansteuerungsfrequenz im Vergleich zur Resonanzfrequenz reduziert ist und derart auch die Rückwirkungen der Überkopplung auf das Messsignal reduziert sind, mit einem ausreichend geringen Abstand zwischen den Anregungspulsen der zur Anregung verwendeten Wechselspannungskomponente. Da es sich bei der Schwingung des Shutters um eine gedämpfte Schwingung handelt, kann es bei geradzahligen Bruchteilen der Resonanzfrequenz, die kleiner als $\omega_0/2$ sind, dazu kommen, dass trotz gleichbleibenden zu bestimmenden externen elektrischen Feldes eine unterwünschte Verringerung der Amplitude des Messsignales erkennbar wäre. Dies wird vermieden, indem die über den Signaleingang an den Aktuator anlegbare Ansteuerungsspannung $u_{DRIVE}$ die Wechselspannungskomponente, $u_{AC}\cdot\sin(\omega t)$ aufweist, deren Frequenz w der halben Resonanzfrequenz entspricht, also $w = \omega_0/2$.

Gemäß einer weiteren bevorzugten Weiterbildung der Erfindung ist vorgesehen, dass die Ansteuerungsspannung, $u_{DRIVE}$, zusätzlich eine Gleichspannungskomponente, $u_{DC}$, umfasst. Wie bereits erwähnt ist eine Gleichspannungskomponente zur Anregung nicht notwendig. Allerdings kann eine zusätzliche Gleichspannungskomponente den Vorteil aufweisen, dass die Amplitude $u_{AC}$ der Wechselspannungskomponente $u_{AC}\cdot\sin(\omega t)$ verringert werden kann.

Gemäß einer weiteren bevorzugten Weiterbildung der Erfindung ist vorgesehen, dass der Aufnehmer zum Erfassen der Schwingung des Shutters dazu ausgestaltet ist, als Ausgangssignal am Signalausgang einen Messstrom bereitzustellen. Es wird also bevorzugt durch eine elektronische Schaltung die Bewegung des Shutters erfasst. Der Aufnehmer stellt am Signalausgang das durch die Schaltung weiterverarbeitete und in den Aktuator rückgekoppelte Ausgangssignal bereit.

In diesem Zusammenhang ist gemäß einer bevorzugten Weiterbildung der Erfindung vorgesehen, dass die Schaltung einen Verstärker zum Verstärken und Wandeln des Ausgangssignales des Aufnehmers in ein Spannungssignal, im Folgenden auch als $u_{READ}$ bezeichnet, umfasst. Der Messstrom wird also bevorzugt für die nachfolgenden Stufen der Schaltung in das Spannungssignal gewandelt und verstärkt. Dafür wird bevorzugt ein Transimpedanzverstärker verwendet.

Gemäß einer weiteren bevorzugten Weiterbildung der Erfindung ist vorgesehen, dass die Schaltung ein elektronisches Filter zum Ausfiltern eines schmalen Frequenzbereiches umfasst, und wobei der schmale Frequenzbereich den geradzahligen Bruchteil der Resonanzfrequenz der Schwingung des Shutters mitumfasst. Dass die zur Anregung der Schwingung des Shutters verwendete Wechselspannungskomponente die Frequenz aufweist, die dem geradzahligen Bruchteil der Resonanzfrequenz der Schwingung des Shutters, und bevorzugt der halben Resonanzfrequenz des Shutters, entspricht, hat den Vorteil, dass in der Schaltung elektronische Filter, die einen schmalbandigen, die Anregungsfrequenz umfassenden Bereich herausfiltern, verwendet werden können, ohne dabei das Nutzsignal - sprich die Resonanzfrequenz - zu beeinträchtigen. Da der Shutter bevorzugt mit der halben Resonanzfrequenz $\omega_0/2$ angetrieben wird, liegt auch das Übersprechen bei der halben Frequenz, während das Nutzsignal bei der mechanischen Schwingfrequenz also der Resonanzfrequenz wo liegt. Durch das elektronische Filter wird bevorzugt nur das Signal in einem schmalen Bereich um $\omega_0/2$ herausgefiltert, während die anderen Frequenzanteile nicht verändert werden. Bevorzugt wird ein Bandsperrfilter und besonders bevorzugt ein Notchfilter, auch Kerbfilter genannt, verwendet. Der Notchfilter weist den Vorteil auf, dass die Rauschbandbreite begrenzt und verringert wird und derart das Rauschen der nachfolgenden Stufen verringert wird. Das vom elektronsichen Filter ausgegebene Signal, das also bevorzugt um die Frequenz der zur Anregung verwendeten Wechselspannungskomponente bereinig ist, wird im Folgenden auch als aufbereitetes Spannungssignal bezeichnet.

Gemäß einer weiteren bevorzugten Weiterbildung der Erfindung ist vorgesehen, dass die Schaltung zur Einstellung einer Phasenverschiebung für die Rückkopplung auf ein ganzzahliges Vielfaches von 360 Grad ein Allpassfilter, oder ein Differenzierer und Integrierer, oder eine Phasenregelschleife umfasst. Um das System in Selbstschwingung zu erhalten, muss das Stabilitätskriterium von Barkhausen erfüllt sein. Die Schwingungsbedingungen, die zu einer dauerhaften Schwingung an einem linearen rückgekoppelten Verstärker mit einer bestimmten Frequenz führen, sehen vereinfacht vor, dass a) die Schleifenverstärkung für eine stabile Oszillation eins sein muss und b) die Phasenverschiebung der Rückkopplungsschleife bei dieser Frequenz ein ganzzahliges Vielfaches von 360° betragen muss. In Bezug zum zweitgenannten Kriterium ist bevorzugt vorgesehen, dass ein Allpassfilter, ein Differenzierer und Integrierer, oder eine Phasenregelschleife verwendet wird, um die notwendige Phasendrehung zu erreichen.

In Zusammenhang mit der Anregung der Schwingung mit dem geradzahligen Bruchteil und insbesondere der halben Resonanzfrequenz, ist bevorzugt vorgesehen, dass die Schaltung einen Frequenzteiler und insbesondere einen Frequenzhalbierer umfasst, der zwischen den Signalausgang des Aufnehmers und den Signaleingang des Aktuators gekoppelt ist. Bevorzugt ist der Frequenzteiler und insbesondere der Frequenzhalbierer zwischen den an den Signalausgang des Aufnehmers gekoppelten Verstärker und den Signaleingang des Aktuators gekoppelt. In anderen Worten verarbeitet der Frequenzteiler und bevorzugt der Frequenzhalbierer also ein Spannungssignal.

Bevorzug ist der Frequenzteiler dazu ausgestaltet, die Frequenz des Spannungssignals zu ermitteln und ein Spannungssignal mit geteilter, und bevorzugt halbierter Frequenz auszugeben. Dies kann erfolgen, indem ein analoges Spannungssignal geteilt, bevorzugt halbiert, wird und ein analoges Signal mit geteilter und bevorzugt halber Frequenz an den Signaleingang des Aktuators rückgekoppelt wird. Dies hat den Vorteil, dass das geteilte und bevorzugt halbierte analoge Signal keine Oberwellen aufweist und somit das Übersprechen geringgehalten werden kann.

Alternativ kann das zu teilende und bevorzugt halbierende analoge Spannungssignal in ein digitales Signal gewandelt werden und digital weiterverarbeitet werden. Die Rückkopplung zum Aktuator kann in diesem Fall mit einem Digitalsignal erfolgen. Auch wenn in diesem Fall noch Oberwellenanteile $3\omega_0$, $5\omega_0$, etc. im rückgekoppelten Signal vorhanden sind, überlagern sich diese aber nicht mit der Resonanzfrequenz wo und zum anderen nimmt deren Energie mit dem Grad der Oberwelle ab. Somit ist auch bei der Rückkopplung eines Digitalsignals die Problematik des Übersprechens gering.

In Bezug zu einer Realisierung des Frequenzteilers in digitaler Logik ist gemäß einer bevorzugten Weiterbildung vorgesehen, dass der Frequenzteiler dazu ausgestaltet ist,

- die Frequenz des aufbereiteten Spannungssignals des Verstärkers mittels Auswertelogik digital zu ermitteln, und/oder
- die geteilte, und insbesondere halbierte Frequenz mittels programmierbarer Logik zu ermitteln, und/oder
- das Spannungssignal mit geteilter und insbesondere halbierter Frequenz über einen digitalen Port und nachgeschalteten Filter oder über direkte digitale Synthese zu erzeugen.

Bevorzugt kann also vorgesehen sein, dass die Frequenz des aufbereiteten Spannungssignals, also $u_{READ}$, mittels einer Auswertelogik digital ermittelt wird. In programmierbarer Logik ist es dann möglich, ein Signal mit der geteilten und bevorzugt halben Frequenz zu erzeugen. Limitierend an diesem Vorgehen ist die Verarbeitungsgeschwindigkeit und Genauigkeit der digitalen Frequenzbestimmung. Die Ausgabe der geteilten und bevorzugt halben Frequenz kann bevorzugt über einen digitalen Port und nachgeschaltete Filter oder alternativ über Lösungen wie direkte digitale Synthese (DDS, *direct, digital synthesis*) Bausteine erfolgen.

Gemäß einer weiteren bevorzugten Weiterbildung der Erfindung ist vorgesehen, dass der Frequenzteiler

- eine Kombination einer Verstärker/Begrenzer-Schaltung umfasst, die dazu ausgestaltet ist, das aufbereitete Spannungssignal des Verstärkers in ein Digitalsignal umzuwandeln, und/oder
- einen Zähler zur Frequenzteilung und bevorzugt Frequenzhalbierung umfasst, und/oder
- aktive Filter zur Filterung von Oberwellen der geteilten und bevorzugt halben Resonanzfrequenz ($\omega_0/2$) umfasst.

In einem bevorzugten Ausführungsbeispiel ist vorgesehen, dass die Frequenzteilung und bevorzugt Frequenzhalbierung über die Kombination einer Verstärker/Begrenzer-Schaltung erfolgt, die das analoge Spannungssignal in ein auswertbares Digitalsignal umwandelt sowie über einen nachfolgenden Zähler, der die Frequenz teilt und bevorzugt halbiert. Anschließend wird bevorzugt mit aktiven Filtern die durch das digitale Ausgangssignal entstandenen Oberwellen von $\omega_0/2$ wieder herausgefiltert.

Gemäß einer weiteren bevorzugten Weiterbildung der Erfindung ist vorgesehen, dass die Schaltung zur Anpassung einer Schwingungsamplitude des Shutters eine automatische Verstärkungsregelung umfasst. Damit die Feldmesseinrichtungen in einem sicheren Betriebsbereich ansteuerbar ist, ist bevorzugt vorgesehen, dass die Verstärkung anpassbar und regelbar ist. Eine Aufgabe dieser Regelung ist bevorzugt, die Schwingungsamplitude das Shutters auch bei verschiedenen Umwelteinflüssen konstant zu halten. Somit werden beispielsweise Einflüsse einer Temperaturänderung auf die Messung kompensiert. Zudem kann eine automatische Verstärkungsregelung beim Startvorgang bzw. Einschwingen des Shutters hilfreich sein. Die Verstärkungsregelung ist bevorzugt dazu eingerichtet, ein Spannungssignal mit geteilter und bevorzugt halbierter Frequenz des Frequenzteilers und als Vergleichssignal ein gefiltertes Spannungssignal eines hinter den Aufnehmer gekoppelten Verstärkers zu empfangen. Als Vergleichssignal dient also in anderen Worten die verstärkte Resonanzfrequenz wo der Schwingung des Shutters. Der Ausgang der Verstärkungsregelung ist bevorzugt ein sauberes Sinussignal mit einer Frequenz von $\omega_0/2n$, mit $n = \{1, 2, 3, 4, ...\}$ und besonders bevorzugt von $\omega_0/2$, und über den Betriebsbereich konstanter Amplitude.

Gemäß einer weiteren bevorzugten Weiterbildung der Erfindung ist vorgesehen, dass die Schaltung zur Verstärkung der an den Signaleingang des Aktuators zuführbaren Ansteuerungsspannung $u_{DRIVE}$ einen Hochspannungsverstärker, einen Spannungswandler, einen Operationsverstärker und/oder einen Transformator umfasst. Bevorzugt werden für den Betrieb der mikromechanischen Feldmesseinrichtung Spannungen > 40 V benötigt, welche einfach mittels des Hochspannungsverstärkers, des Spannungswandlers, des Operationsverstärkers und/oder des Transformators erreicht werden können.

In Bezug zur Feldmesseinrichtung ist gemäß einer weiteren bevorzugten Weiterbildung der Erfindung vorgesehen, dass die Feldmesseinrichtung frei von einer Schirmstruktur zum Abschirmen der Sensorelektroden von kapazitiver Kopplung mit dem Aktuator ist. Entsprechend ist der Aufbau der Feldmesseinrichtung wenig komplex und einfach. Weiterhin ist bevorzugt vorgesehen, dass die Sensorelektroden der Feldmesseinrichtung als Fingerelektroden ausgeführt sind.

Weitere technische Merkmale und Vorteile der Feldmesseinrichtung sowie auch des Verfahrens zum Ansteuern der Feldmesseinrichtung ergeben sich für den Fachmann aus der obigen Beschreibung der Schaltung, sowie aus der Beschreibung der bevorzugten Ausführungsformen.

Zusammengefasst ergeben sich durch die Ansteuerung der Feldmesseinrichtung mit der Ansteuerungsspannung $u_{DRIVE}$, die wenigstens die Wechselspannungskomponente $u_{AC} \cdot \sin(\omega t)$, welche mit einem ganzzahligen Bruchteil der Resonanzfrequenz und bevorzugt mit der halben Resonanzfrequenz $\omega_0/2$ des Shutters schwingt, einige Vorteile: Im Gegensatz zu der aus dem Stand der Technik bekannten Ansteuerung mit $\omega_0$, erfolgt eine spektrale Trennung zwischen der Frequenz der Ansteuerung und der Frequenz des Messsignales, das mit der Resonanzfrequenz des Shutters schwingt. Die Nutzsignale schwingen weiterhin mit $\omega_0$, während die Ansteuerung mit $\omega_0/2$ erfolgt. Durch elektronische Filter lassen sich die Rauschbandbreite begrenzen und verringern und damit das Rauschen der nachfolgenden Stufen verringern. Dies ermöglicht auf aufwändige Schirmstrukturen zu verzichten, da verbleibende Störungen der Ansteuerung ($\omega_0/2$, $3/2\omega_0$) sowohl analog oder auch in der Auswerteelektronik digital herausgefiltert werden können.

Beispiele und Ausführungsformen der vorliegenden Erfindung werden noch in exemplarischer Weise mit Bezug auf die Figuren 1 bis 3 beschrieben:

Figur 1 zeigt schematisch ein Architekturbild einer Schaltung gemäß einem bevorzugten Ausführungsbeispiel der Erfindung;

Figur 2 zeigt schematisch ein Schaltbild einer Frequenzhalbierung gemäß einem bevorzugten Ausführungsbeispiel der Erfindung; und

Figur 3 zeigt schematisch in a) im Frequenzraum den Effekt einer Ansteuerungsschaltung gemäß dem Stand der Technik und in b) im Frequenzraum den Effekt einer Ansteuerungsschaltung gemäß Figur 1.

In den Ausführungsbeispielen und Figuren können gleiche oder gleich wirkende Elemente jeweils mit den gleichen Bezugszeichen versehen sein. Die dargestellten Elemente und deren Größenverhältnisse untereinander sind grundsätzlich nicht als maßstabsgerecht anzusehen, vielmehr können einzelne Elemente, zur besseren Darstellbarkeit und/oder zum besseren Verständnis im Verhältnis größer dimensioniert dargestellt sein.

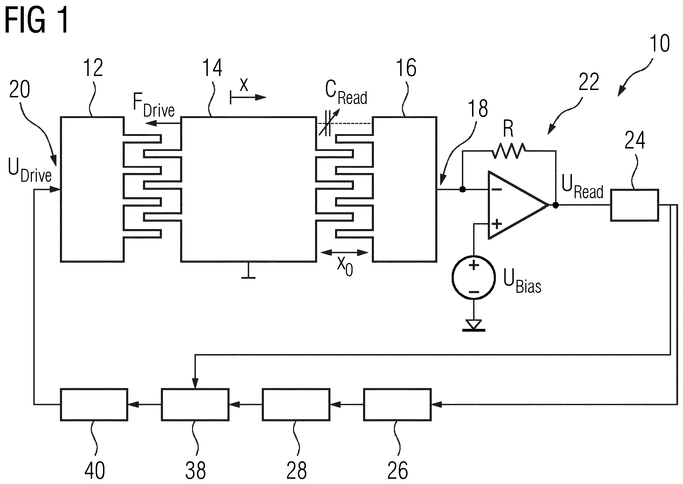

Die Figur 1 zeigt schematisch ein Architekturbild einer Schaltung 10 zum Ansteuern einer mikromechanischen Feldmühle gemäß einem bevorzugten Ausführungsbeispiel der Erfindung. Die Feldmühle zum Bestimmen einer Feldstärke eines elektrischen Feldes weist einen geerdeten Shutter 14 auf, der dazu konfiguriert ist, elektrostatisch in Schwingung versetzt zu werden. Vorliegend erfolgt dies mit einem Aktuator 12 der Schaltung 10. Zudem weist die Schaltung 10 einen Aufnehmer 16 zum Erfassen der Schwingung des Shutters 14 der Feldmühle auf. Das Messprinzip der Feldmühle basiert darauf, dass der Aufnehmer 16 Sensorelektroden zum Erzeugen eines Messsignales 42 umfasst, wobei die Sensorelektroden mittels des Shutters 14 wiederholt von dem zu messenden elektrischen Feld abschirmbar und wieder dem Feld aussetzbar sind, derart dass die Sensorelektroden durch Influenz des zu messenden elektrischen Feldes abwechselnd entladbar und aufladbar sind. In Figur 1 schwingt der Shutter 14 in der Bildebene lateral entlang der x-Richtung.

Die Ansteuerung des Aktuator 12 erfolgt vorliegend über die Schaltung 10, die als selbstschwingendes System ausgestaltet ist. Ein Signalausgang 18 des Aufnehmers 16 ist dafür zur Rückkopplung mit einem Signaleingang 20 des Aktuators 12 gekoppelt. Zudem ist vorgesehen, dass eine über den Signaleingang 20 an den Aktuator 12 anlegbare Ansteuerungsspannung $u_{DRIVE}$ wenigstens eine Wechselspannungskomponente $u_{AC} \cdot \sin(\omega t)$ mit einer Frequenz w umfasst, die der halben Resonanzfrequenz $\omega_0/2$ der Schwingung des Shutters 14 entspricht. Um dieses Verhalten zu zeigen, weist die Schaltung 10 im vorliegende Ausführungsbeispiel mehrere Stufen auf, die nachfolgend einzeln beschrieben werden:

Zunächst erfasst der Aufnehmer 16 durch eine elektronische Schaltung die Bewegung des Shutters 14 und erzeugt als Ausgangssignal am Signalausgang 18 einen Messstrom. Dieses Signal wird für die nachfolgenden Stufen in einem Transimpedanzverstärker 22 verstärkt und in ein Spannungssignal $u_{READ}$ gewandelt.

Mit dem dem Transimpedanzverstärker 22 nachgeschalteten Notchfilter 24, einem schmalbandigen Filter, wird das übersprechende Signal vom Aktuator 12 herausgefiltert. Da der Shutter 14 mit halber Resonanzfrequenz $\omega_0/2$ angetrieben wird, liegt auch das Übersprechen bei der halben Frequenz, während das zur Rückkopplung verwendbare Nutzsignal bei der Resonanzfrequenz wo liegt. Somit wird durch den Notchfilter 24 das Signal in einem schmalen Bereich um $\omega_0/2$ herausgefiltert, während die anderen Frequenzanteile des Signales nicht verändert werden.

Die dem Notchfilter 24 nachgelagerte Stufe weist einen Allpassfilter 26 auf und sorgt entsprechend dafür, dass eine Phasenverschiebung für die Rückkopplung auf ein ganzzahliges Vielfaches von 360 Grad eingestellt ist.

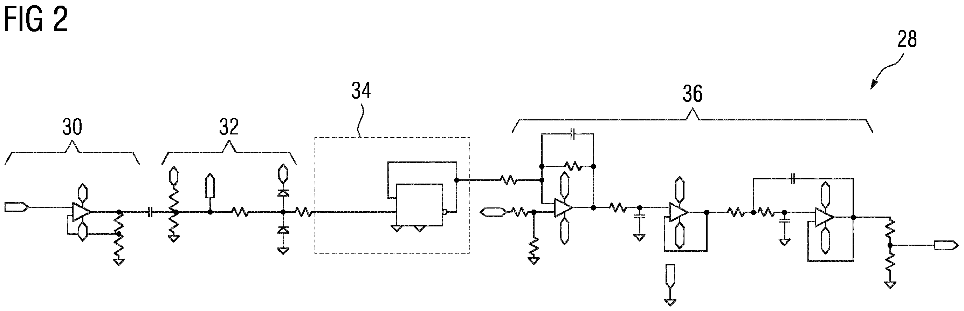

Dem Allpassfilter 26 schließt sich ein Frequenzteiler 28, vorliegend ein Frequenzhalbierer 28, an. Die Figur 2 zeigt schematisch ein Schaltbild dieser Stufe der Schaltung 10 gemäß einem bevorzugten Ausführungsbeispiel der Erfindung. In dieser Stufe wird die Resonanzfrequenz wo erfasst und halbiert wieder ausgegeben. Dies erfolgt in der konkreten Realisierung über die Kombination einer Verstärker/Begrenzer Schaltung, die vorliegend von einer Vorverstärkung 30, und einer Arbeitspunkteinstellung 32 gebildet wird, die das Signal in ein auswertbares Digitalsignal umwandelt. Nachfolgend wird über einen digitalen Frequenzhalbierer 34 mittels eines Zählers die Frequenz halbiert. Anschließend wird mit aktiven Filtern, vorliegend mittels Tiefpassfiltern 36 die durch das digitale Ausgangssignal entstandenen Oberwellen von $\omega_0/2$ wieder herausgefiltert.

Zurück zu Figur 1 ist ersichtlich, dass sich hinter der Stufe der Frequenzhalbierung 28 eine automatische Verstärkungsregelung 38, *automatic gain control,* anschließt. In dieser Stufe wird vorliegend die Verstärkung des Signales angepasst und geregelt, um die Schwingungsamplitude des Shutters 14 auch bei unterschiedlichen Umwelteinflüssen konstant zu halten. Als Vergleichssignal dient das durch den Notchfilter 24 erzeugte gefilterte Spannungssignal. Das Ausgangsignal der automatischen Verstärkungsregelung 38 ist vorliegend ein Sinussignal mit der Frequenz $\omega_0/2$ mit einer über den Betriebsbereich konstanter Amplitude.

Bevor das Ausgangssignal der automatischen Verstärkungsregelung 38 über den Signaleingang 20 an den Aktuator 12 als Ansteuerungsspannung $u_{DRIVE}$ zurückgekoppelt wird, wird das Signal durch einen Hochspannungsverstärker 40 verstärkt und vorliegend auf eine Spannung von > 40 V gebracht. Für die Spannungserhöhung wird in diesem Ausführungsbeispiel ein 1:N Transformator verwendet.

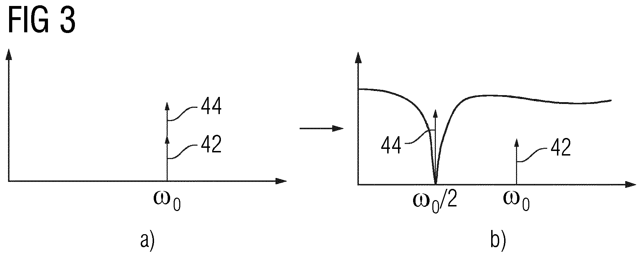

Die Figur 3 zeigt schematisch in b) im Frequenzraum den Effekt der Ansteuerung über die in Figur 1 gezeigte Schaltung 10 im Vergleich zu einer Ansteuerungsschaltung gemäß dem Stand der Technik in a), bei der der Aktuator 12 mit der Resonanzfrequenz wo, statt der halben Resonanzfrequenz $\omega_0/2$ angesteuert wird. In Figur 3a) ist zu erkennen, dass das Messsignal 42 der Feldmühle bei der gleichen Frequenz wo schwingt, wie ein durch die Ansteuerung des Aktuators 12 vorhandenes Interferenzsignal 44. Hingegen ist in Figur 3b) ersichtlich, dass durch eine Ansteuerung des Aktuators 12 mit der halben Resonanzfrequenz $\omega_0/2$ eine spektrale Trennung vorliegt, was eine Differenzierung des Messsignals 42 vom Interferenzsignal 44 und entsprechend eine genauere Messung des elektrischen Feldes ermöglicht.

Bezugszeichenliste

10 Schaltung
12 Aktuator
14 Shutter
16 Aufnehmer
18 Signalausgang des Aufnehmers
20 Signaleingang des Aktuators
22 Verstärker, Transimpedanzverstärker
24 elektronisches Filter, Notchfilter
26 Allpassfilter
28 Frequenzteiler, Frequenzhalbierer
30 Vorverstärkung
32 Arbeitspunkteinstellung
34 Digitaler Frequenzhalbierer
36 Tiefpassfilter
38 Verstärkungsregelung
40 Hochspannungsverstärker
42 Messsignal
44 Interferenzsignal

$u_{DRIVE}$ Ansteuerungsspannung
$u_{AC}\cdot\sin(\omega t)$ Wechselspannungskomponente
$\omega_0$ Resonanzfrequenz
$\omega_0/2$ halbe Resonanzfrequenz
$u_{DC}$ Gleichspannungskomponente
$u_{READ}$ Spannungssignal

## Patentansprüche

1. Schaltung (10) zum Ansteuern einer Feldmesseinrichtung, insbesondere einer mikromechanischen Feldmühle,

   wobei die Schaltung einen elektrostatischen Aktuator (12) zum Versetzen eines Shutters (14) der Feldmesseinrichtung in Schwingung und einen Aufnehmer (16) zum Erfassen der Schwingung des Shutters (14) umfasst, wobei ein Signalausgang (18) des Aufnehmers (16) zur Rückkopplung mit einem Signaleingang (20) des Aktuators (12) gekoppelt ist, und
   wobei die Schaltung (10) derart ausgestaltet ist, dass eine über den Signaleingang (20) an den Aktuator (12) anlegbare Ansteuerungsspannung ($u_{DRIVE}$) wenigstens eine Wechselspannungskomponente ($u_{AC} \cdot \sin(\omega t)$) mit einer Frequenz (w) umfasst, die einem geradzahligen Bruchteil einer Resonanzfrequenz (wo) der Schwingung des Shutters (14) entspricht.

2. Schaltung (10) nach dem vorhergehenden Anspruch, wobei der geradzahlige Bruchteil der Resonanzfrequenz ($\omega_0$) die halbe Resonanzfrequenz ($\omega_0/2$) der Schwingung des Shutters (14) ist.

3. Schaltung (10) nach einem der vorhergehenden Ansprüche, wobei die Ansteuerungsspannung ($u_{DRIVE}$) zusätzlich eine Gleichspannungskomponente ($u_{DC}$) umfasst.

4. Schaltung (10) nach einem der vorhergehenden Ansprüche, wobei der Aufnehmer (16) zum Erfassen der Schwingung des Shutters (14) dazu ausgestaltet ist, als Ausgangssignal am Signalausgang (18) einen Messstrom bereitzustellen.

5. Schaltung (10) nach einem der vorhergehenden Ansprüche, wobei die Schaltung (10) einen Verstärker (22) und insbesondere einen Transimpedanzverstärker, zum Verstärken und Wandeln des Ausgangssignales des Aufnehmers (16) in ein Spannungssignal ($u_{READ}$) umfasst.

6. Schaltung (10) nach einem der vorhergehenden Ansprüche, wobei die Schaltung (10) ein elektronisches Filter (24), insbesondere ein Notchfilter, zum Ausfiltern eines schmalen Frequenzbereiches umfasst, und wobei der schmale Frequenzbereich den geradzahligen Bruchteil der Resonanzfrequenz ($\omega_0$) der Schwingung des Shutters (14) mitumfasst.

7. Schaltung (10) nach einem der vorhergehenden Ansprüche, wobei die Schaltung (10) zur Einstellung einer Phasenverschiebung für die Rückkopplung auf ein ganzzahliges Vielfaches von 360 Grad ein Allpassfilter (26), oder ein Differenzierer und Integrierer, oder eine Phasenregelschleife umfasst.

8. Schaltung (10) nach einem der vorhergehenden Ansprüche, wobei die Schaltung (10) einen Frequenzteiler (28), und insbesondere einen Frequenzhalbierer (28) umfasst, der zwischen den Signalausgang (18) des Aufnehmers (16) und den Signaleingang (20) des Aktuators (12) gekoppelt ist, und bevorzugt dazu ausgestaltet ist, die Frequenz eines aufbereiteten Spannungssignals eines Verstärkers (22) zu ermitteln und ein Spannungssignal mit geteilter und bevorzugt halbierter Frequenz auszugeben.

9. Schaltung (10) nach dem vorhergehenden Anspruch, wobei der Frequenzteiler (28) dazu ausgestaltet ist

   - die Frequenz des aufbereiteten Spannungssignals des Verstärkers (22) mittels Auswertelogik digital zu ermitteln, und/oder
   - die geteilte, und insbesondere halbierte Frequenz mittels programmierbarer Logik zu ermitteln, und/oder
   - das Spannungssignal mit geteilter und insbesondere halbierter Frequenz über einen digitalen Port und nachgeschalteten Filter oder über direkte digitale Synthese zu erzeugen.

10. Schaltung (10) nach Anspruch 8, wobei der Frequenzteiler (28)

    - eine Kombination einer Verstärker/Begrenzer-Schaltung (30, 32) umfasst, die dazu ausgestaltet ist, das aufbereitete Spannungssignal des Verstärkers (22) in ein Digitalsignal umzuwandeln, und/oder
    - einen Zähler (34) zur Frequenzteilung umfasst, und/oder
    - aktive Filter (36) zur Filterung von Oberwellen der geteilten und bevorzugt halbierten Resonanzfrequenz ($\omega_0/2$) umfasst.

**11.** Schaltung (10) nach einem der vorhergehenden Ansprüche, wobei die Schaltung (10) zur Anpassung einer Schwingungsamplitude des Shutters (14) eine automatische Verstärkungsregelung (38) umfasst, wobei die Verstärkungsregelung (38) bevorzugt dazu eingerichtet ist, ein Spannungssignal mit geteilter Frequenz eines Frequenzteilers (28) und bevorzugt eine halbierte Frequenz eines Frequenzhalbierers (28) und als Vergleichssignal ein gefiltertes Spannungssignal eines hinter den Aufnehmer (16) gekoppelten Verstärkers (22) zu empfangen.

**12.** Schaltung (10) nach einem der vorhergehenden Ansprüche, wobei die Schaltung (10) zur Verstärkung der an den Signaleingang (20) des Aktuators (12) zuführbaren Ansteuerungsspannung ($u_{DRIVE}$) einen Hochspannungsverstärker (40), einen Spannungswandler, einen Operationsverstärker und/oder einen Transformator umfasst.

**13.** Verfahren zum Ansteuern einer Feldmesseinrichtung, insbesondere einer mikromechanischen Feldmühle, mit einer Schaltung (10) nach einem der vorhergehenden Ansprüche, umfassend den Schritt

- Versetzen des Shutters (14) in Schwingung durch Anlegen einer Ansteuerungsspannung ($u_{DRIVE}$) an den Aktuator (12) mit wenigstens einer Wechselspannungskomponente ($u_{AC} \cdot \sin(\omega t)$) mit einer Frequenz (w), die einem geradzahligen Bruchteil einer Resonanzfrequenz (wo) der Schwingung des Shutters (14) entspricht.

**14.** Feldmesseinrichtung, insbesondere mikromechanische Feldmühle, zum Messen einer elektrischen Feldstärke umfassend

- einen geerdeten Shutter (14), der dazu konfiguriert ist, elektrostatisch in Schwingung versetzt zu werden,
- einen Aktuator (12) zum Versetzen des Shutters (14) in Schwingung, und
- einen Aufnehmer (16) zum Erfassen der Schwingung des Shutters (14),

wobei der Aufnehmer (16) Sensorelektroden zum Erzeugen eines Messsignales (42) der Feldmesseinrichtung umfasst, wobei die Sensorelektroden mittels des Shutters (14) wiederholt von dem zu messenden Feld abschirmbar und wieder dem Feld aussetzbar sind, derart dass die Sensorelektroden durch Influenz des zu messenden elektrischen Feldes abwechselnd entladbar und aufladbar sind,
wobei ein Signalausgang (18) des Aufnehmers (16) zur Rückkopplung mit einem Signaleingang (20) des Aktuators (12) gekoppelt ist, und
wobei die Feldmesseinrichtung derart ausgestaltet ist, dass eine über den Signaleingang (20) an den Aktuator (12) anlegbare Ansteuerungsspannung ($u_{DRIVE}$) wenigstens eine Wechselspannungskomponente ($u_{AC} \cdot \sin(\omega t)$) mit einer Frequenz (w) umfasst, die einem geradzahligen Bruchteil einer Resonanzfrequenz (wo) der Schwingung des Shutters (14) entspricht.

**15.** Feldmesseinrichtung nach dem vorhergehenden Anspruch, wobei die Feldmesseinrichtung frei von einer Schirmstruktur zum Abschirmen der Sensorelektroden von kapazitiver Kopplung mit dem Aktuator (12) ist.

FIG 1

10
12
14
16
18
20
22
24
26
28
38
40
x
$F_{Drive}$
$C_{Read}$
$U_{Drive}$
R
$U_{Read}$
$x_0$
$U_{Bias}$

FIG 2
28
30
32
34
36

# FIG 3

44
42
$\omega_0$
a)
44
42
$\omega_0/2$
$\omega_0$
b)

Europäisches
Patentamt
European
Patent Office
Office européen
des brevets

# EUROPÄISCHER RECHERCHENBERICHT

Nummer der Anmeldung
EP 24 17 5802

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X<br>Y | CN 113 765 516 A (AVIC XIAN FLIGHT AUTOMATIC CONTROL RES INST) 7. Dezember 2021 (2021-12-07) * Absätze [0030] - [0057]; Ansprüche 1-8; Abbildung 1 * | 1-12<br>13-15 | INV. G01R29/12 G01R15/16 |
| X | US 5 530 342 A (MURPHY HUGH J [US]) 25. Juni 1996 (1996-06-25) * Spalte 4 - Spalte 7; Ansprüche 1-12; Abbildungen 1-4 * | 1-15 | |
| X | CN 1 490 926 A (UNIV TSINGHUA [CN]) 21. April 2004 (2004-04-21) * Seite 4 - Seite 7; Ansprüche 1-6; Abbildungen 1-3 * | 1-15 | |
| Y | DE 10 2008 052477 A1 (SIEMENS AG [DE]) 10. Juni 2010 (2010-06-10) * Absätze [0007] - [0022]; Ansprüche 1-9; Abbildung 1 * | 13-15 | RECHERCHIERTE SACHGEBIETE (IPC) |
| A | CN 101 860 338 A (UNIV NORTHWESTERN POLYTECHNIC) 13. Oktober 2010 (2010-10-13) * Absätze [0002] - [0038]; Ansprüche 1-6; Abbildungen 1-10 * | 1-15 | G01R |
| A | WO 2013/117228 A1 (SIEMENS AG [DE]; MAKUTH JENS [DE] ET AL.) 15. August 2013 (2013-08-15) * Seite 1 - Seite 7; Ansprüche 1-10; Abbildungen 1-9 * | 1-15 | |

Der vorliegende Recherchenbericht wurde für alle Patentansprüche erstellt

3

| Recherchenort | Abschlußdatum der Recherche | Prüfer |
|---|---|---|
| München | 2. Oktober 2024 | Bilzer, Claus |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
& : Mitglied der gleichen Patentfamilie, übereinstimmendes Dokument

EPO FORM 1503 03.82 (P04C03)

## ANHANG ZUM EUROPÄISCHEN RECHERCHENBERICHT ÜBER DIE EUROPÄISCHE PATENTANMELDUNG NR.

EP 24 17 5802

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

02-10-2024

| Im Recherchenbericht angeführtes Patentdokument | Datum der Veröffentlichung | Mitglied(er) der Patentfamilie | Datum der Veröffentlichung |
|---|---|---|---|
| CN 113765516 A | 07-12-2021 | KEINE | |
| US 5530342 A | 25-06-1996 | DE 69525405 T2 | 02-10-2002 |
| | | EP 0704674 A2 | 03-04-1996 |
| | | JP 3894587 B2 | 22-03-2007 |
| | | JP H08114461 A | 07-05-1996 |
| | | US 5530342 A | 25-06-1996 |
| CN 1490926 A | 21-04-2004 | KEINE | |
| DE 102008052477 A1 | 10-06-2010 | KEINE | |
| CN 101860338 A | 13-10-2010 | KEINE | |
| WO 2013117228 A1 | 15-08-2013 | EP 2771700 A1 | 03-09-2014 |
| | | WO 2013117228 A1 | 15-08-2013 |

EPO FORM P0461

Für nähere Einzelheiten zu diesem Anhang : siehe Amtsblatt des Europäischen Patentamts, Nr.12/82